# EUROPEAN PATENT SPECIFICATION

(11) **EP 1 677 389 B1**
(45) Date of publication and mention of the grant of the patent: **04.02.2009**
(21) Application number: 05445098.6
(22) Date of filing: 22.12.2005
(51) Int. Cl.: H01R 12/34

(54) **Power terminal and a unit comprising such power terminal**
Anschlussklemme und Leistungseinheit mit dieser Anschlussklemme
Borne d'alimentation et unité comprenant cette borne

(30) Priority: 27.12.2004 SE 0403177
(43) Date of publication of application: 05.07.2006
(73) Proprietor: Danaher Motion Stockholm AB, 135 70 Stockholm (SE)
(72) Inventor: Karlsson, Ulf Bengt Ingemar, 128 48 Bagarmossen (SE); Berglund, Jan Anders, 176 70 Järfälla (SE)
(74) Representative: Estreen, Lars J.F.

(56) References cited:
- EP-A- 0 784 354
- EP-A- 1 357 638
- US-A- 4 969 065
- US-A1- 2004 137 803

## Description

### FIELD OF INVENTION

The present invention relates generally to power terminals and more particularly to a power terminal, particularly for electrical connection of an electric cable to a circuit board, which is easy to mount, flexible in new designs and which makes efficient use of circuit board area. A unit comprising such a power terminal is also provided.

### BACKGROUND

Power terminals are used on devices such as drive units for electric motors. A conventional power terminal tower in a drive unit is often split in two halves where one goes up to the cover and one goes down to the power board and the halves are not on top of each other. Since the electrical signal in the terminal is used on both a control board and a power board both halves are mounted to the control board, which takes up a lot of space on the board, or one of the halves is placed outside of the board and is connected via a bus bar (normally a copper plate) which gives a more expensive solution and a bigger drive. Both solutions give a complicated assembly with many screws, often in inconvenient directions, and they also make the cooling of the terminal worse because of the high thermal resistance to the heat sink. Furthermore these solutions make the cover and the control board tightly tied together and the terminal position cannot be moved on the cover without modifying the one on the control board and vice versa.

Instead of terminals with circular cross-sections some designs use flat plates (bus bars) to take the signals from the outside of the cover and into the boards. One problem here is to achieve a good sealing through the cover combined with robustness and ease of assembly. The use of flat plates often require soldering fixtures in production to keep the bus bars upright, and there can be soldering problems if the boards are slightly bent. To avoid mechanical forces from the outside going all the way down to the solder joints on the board you may want to insert some bends in the plate, but bends are costly because they are often made manually.

Sealing of the area between the power terminal and the cover of the drive unit is important in order to prevent leakage of water etc. into the drive unit. One way of achieving a good sealing is to use O-rings. However, O-ring gaskets that are not rolling often have to be lubricated when mounted into the cover. That is an extra cost and also an extra risk that the lubricant, which often contains oil is misplaced on the surface where the cable shoe is pressed to the terminal with the risk of a bad electrical connection.

Also, gaskets that are not rolling cannot be compressed that much because of the risk that they will get stuck, and they therefore have to be made of harder rubber that demands tighter tolerances on terminal and cover. With a softer rubber gasket the demands on the cover and board tolerances and strength decrease.

When the gasket is rolling there is no need for a groove on the top part of the power terminal, and without that groove the terminal can be die cast with a much simpler casting tool (no slides). The draft on the top of the terminal and the cover has to be there anyway for the cast and molding process. The groove also leaves a parting line from the casting process that has to be removed in order to maintain a good sealing.

EP-A-0 784 354 discloses a high power cable terminal connector with a solid metal body that is spot welded (9) to a U-shaped base that has a number of prongs that can be pressed in holes in a circuit board to provide points of contact.

EP-A-1 357 638 discloses a reconnection mechanism having tooth comb connectors with an electrical connector connected. There is a contact strip cooperating with the connection wire and connected to the contact wire with a grip. A blocking strip connects to the conductor grip/release. There is a window to allow a rigid strip to pass.

US-A-4 969 065 discloses a circuit board assembly including two parallel boards and a spacer comprising a body portion disposed between the boards.

### SUMMARY OF THE INVENTION

An object of the present invention is to provide a power terminal which is easy to mount, flexible in new designs and which makes efficient use of circuit board area.

Another object is to provide a power terminal, which provides efficient cooling.

Yet another object is to provide a power terminal which is cheap and easy to cast and surface treat.

A further object is to provide a power terminal with low demands on surrounding tolerances combined with good water protection.

The invention is based on the realization that a crank shaped power terminal having a main body and an eccentric body integral thereto, wherein a space is provided at the bottom of the power terminal adjacent to the eccentric body, provides a means for securing the terminal in an easy and efficient way while also providing for mounting of a current measurement device.

According to the invention there is provided a power terminal as defined in appended claim 1.

There is also provided a unit comprising a power terminal according to the invention.

Thus there is provided a power terminal having a general crank shape providing for a space wherein a component, such as a current measuring device can be provided.

In a preferred embodiment, a means for maintaining a lateral position comprises a pin for positioning in a hole in the circuit board.

Further preferred embodiments are defined by the dependent claims.

### BRIEF DESCRIPTION OF DRAWINGS

The invention is now described, by way of example, with reference to the accompanying drawings, in which:
Fig. 1 is an overall view of an arrangement including a battery, an electric motor, and a drive unit according to the invention for controlling the operation of the motor;
Fig. 2 is a detailed plan view of the drive unit shown in Fig. 1;
Fig. 3 is a cross-sectional view of the drive unit showing a power terminal according to the invention;
Fig. 4 is a detailed view of the area designated A-A in Fig. 3;
Fig. 5 is an exploded perspective view of the power terminal shown in Fig. 3;
Fig. 6 is a side view of the power terminal shown in Fig. 3;
Fig. 7 shows an alternative embodiment of a power terminal according to the invention adapted for high currents;
Figs. 8, 9, and 10 show further alternative embodiments of a power terminal according to the invention;
Fig. 11 shows a standoff for use with a power terminal according to the invention; and
Fig. 12 shows the standoff of Fig. 11 mounted to a circuit board.

### DETAILED DESCRIPTION OF THE INVENTION

In the following a detailed description of preferred embodiments of the present invention will be given.

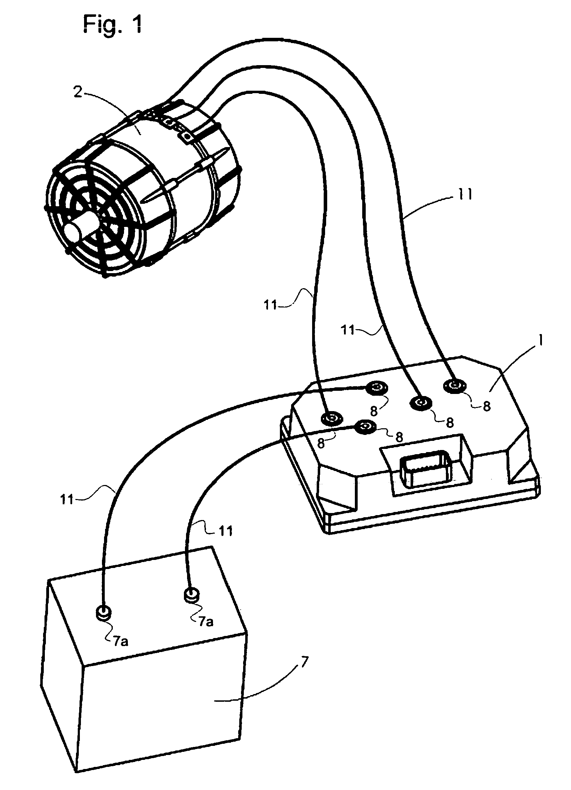

In Fig. 1, an overall view of a drive arrangement is shown. This arrangement includes a drive unit 1 connected to a battery 7 by means of two cables 11 connected to terminals 8, 7a on the drive unit and the battery, respectively. The drive unit is adapted for power control of an electric motor 2 and is connected thereto by means of three cables 11. These cables are, like the battery cables, connected to a respective power terminal 8 on the drive unit.

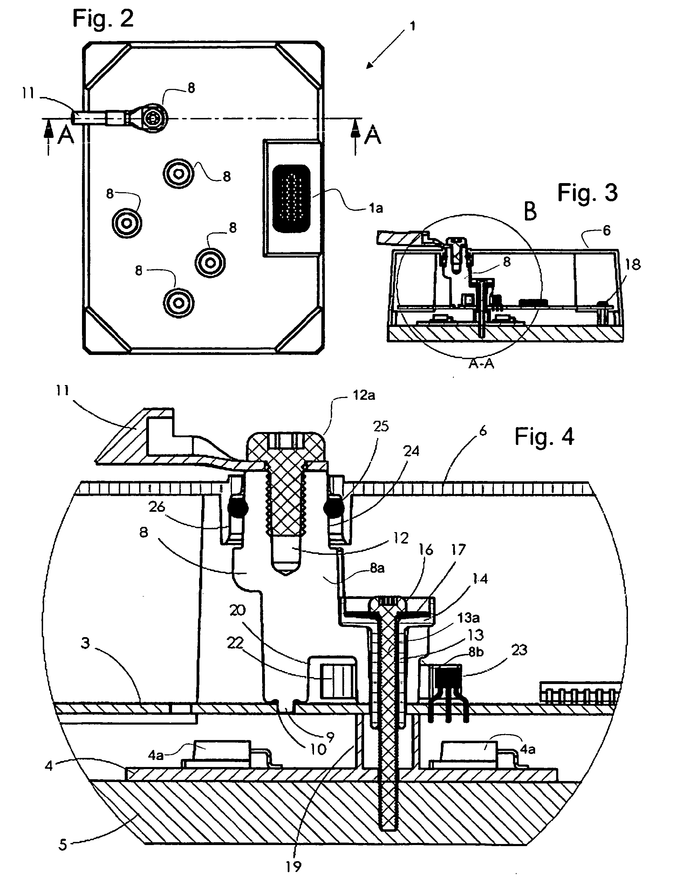

The power terminals appear more clearly in the plan view of Fig. 2. The cables 11, one of which is shown in Fig. 2, are attached to the power terminals 8 by means of a screw arrangement, as will be described in detail below. The drive unit 1 also has a pin connector 1a used for connecting the drive unit to a control computer, for example.

The interior of the drive unit 1 for power control of an electric motor will now be described in detail with reference to Figs. 3 and 4. The interior is enclosed by a plastic cover 6. Inside the cover there are provided two mutually parallel circuit boards: a control board 3 and a power board 4 mounted on a heat sink 5, see fig. 4. The control board 3 mounts a number of low power components, such as a hall element 23. The power board 4 mounts a number of power components, such as power transistors 4a, which operate to distribute power received from the battery 7 to the motor 2 with the help of the power terminals 8.

Each of the power terminals 8, which are essentially cranked shaped and made of an electrically conductive material, comprises a solid body 8a which extends vertically between the cover 6 and the control board 3. In the upper end of the body there is provided coaxially a threaded hole 12 adapted for receiving a screw 12a used for attaching the cable 11 to the solid body 8a of the power terminal. In the lower end thereof, the solid body 8a ends in an alignment pin 9 for positioning accuracy in a tight hole 10 in the control board 3. The alignment pin 9 prevents rotation of the terminal, particularly when a cable 11 is connected to the threaded hole 12 from the outside of the unit by means of a three point attachment, as will be explained below.

Since the alignment pin 9 is provided on the opposite side of the threaded hole 12 on top of the body they both can easily be masked when the power terminal is surface treated, wherein a fixture holding the terminal in an electrochemical bath also does the masking job. Without the masking the diameter of the alignment pin would not be stable since the thickness of the metal layers that are added during the surface treatment is not the same all over the terminal and it can also vary from terminal to terminal.

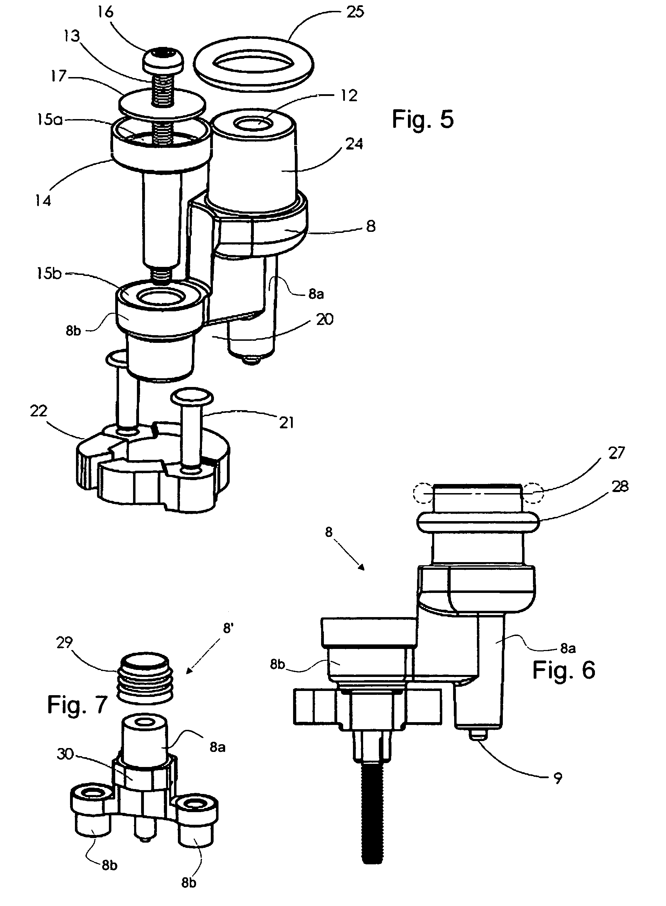

An eccentric portion 8b extends from the solid body 8a and being integral therewith. This gives the terminal an essentially cranked shaped profile when viewed from the side, see Fig. 6 for example. A through hole 13 extends vertically through the eccentric portion and is adapted to receive a mounting screw 13a having a screw head 16. The crank shape of the power terminal makes it easy to mount with only one such mounting screw 13a that optionally can be electrically insulated from the body 8a and eccentric portion 8b by means of a plastic insulator 14. The eccentric portion 8b and the plastic insulator 14 have a respective conical surface 15a, 15b under the screw head 16, see Fig. 5, to enable the use of a flat spring plate washer 17 that bends when the screw is mounted and therefore provides for a good electrical connection. The mounting screw 13a is fixed in the same direction as other screws 18 attaching the boards to the heat sink, see Fig. 3, and this makes the mounting screw quick and easy to assemble.

Without a conical surface under the screw head you have to use a more expensive washer (pre bent) that sometimes have to be mounted in the right direction in order to be efficient and hence can be faulty mounted. With a flat spring washer it is easy to modify the force by simply punching it out from a thicker or thinner plate, using the same punching tool.

A current spacer 19 made of an electrically and thermally conductive material is provided between the control board 3 and the power board 4 and is soldered to the power board. Such a current spacer is described in the European patent publication EP 0711107 B1 and functions as a conductor between the control board and the power board. The fact that the power terminal and the current spacer 19 are on top of each other also makes the heat transfer down to the heat sink efficient due to the resulting low thermal resistance between the terminal 8 and the heat sink 5.

The crank shape also gives room for a space 20 at the bottom of the terminal for a current measurement device 22 mounted with plastic rivets 21, see Fig. 5. The current measurement device comprises an iron core 22 that, together with a hall element 23 are arranged to indirectly measure the current through the terminal by measuring the magnetic field induced in the iron core.

With reference to Figs. 4-6, at the top of the body 8a there is provided a drafted surface 24 that can be used for a water protection gasket 25 that does not leave any force striving to lift the cover 6 after mounting, but simply pushes the gasket out towards an equally drafted surface 26 on the cover, see Fig. 4. The gasket is rolling from a top position 27 indicated by dashed lines in Fig. 6 down to a mounted position 28 when the cover is mounted and this rolling makes it easy to mount with very low friction. This design also opens up for the use of a special purpose molded multi flange gasket 29, see Fig. 7. The drafted surface preferably has an angle of approximately 1-2°, more preferably 1.5°.

Since the cables connecting the terminals from the outside are relatively thick because of the high currents, such as above 10 Amperes, they need to be connected with big screws, typically M6 or bigger. In the lower part of the terminal on the other hand, too big screws are unwanted because they would take up too much space on the boards. In an alternative embodiment shown in Fig. 7, in the case of very high currents on some of the terminals, a special terminal 8' is provided with more than one eccentric portion 8b for a respective mounting screw. In this way, the lower part of the terminal is not the limiting factor for high currents, and you can still use the same kind of screws, washers and insulators.

It can sometimes be of help for the PCB layout to receive the same signal on two different places on the boards, especially on the power board that normally is a single layer PCB. With a multi mounting screw terminal shown in Fig. 7 the alignment pin could be omitted if the demands for position accuracy so admits. The anti rotation is now taken care of by the multiple mounting screws.

When designing new drive units the flexibility of the crank shaped power terminals makes it easier to reuse the same cover for new circuit boards or use the same boards with a new cover by rotating the crank with either the top or the bottom fixed.

When designing new circuit boards (with a reused cover) the power terminals can be rotated with the top fixed. Also, the current measurement iron core 22 can be rotated relative to the power terminal in almost any direction, all this flexibility makes it easier to do the circuit board layout.

In some designs there is just one board serving as both power and control board. In that case the heat sink is simply reshaped by putting in some distances with threaded holes in the middle that replaces the current spacer on the power board and using shorter mounting screws.

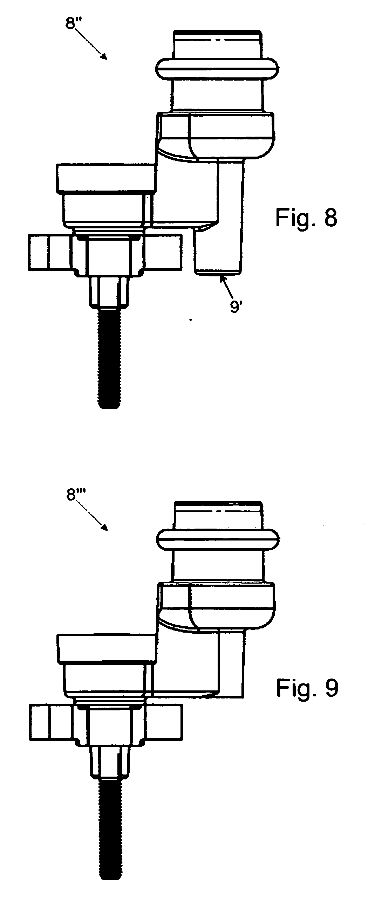

In the embodiments described with reference to Figs. 3-7, an alignment pin 9 is provided to maintain the lateral position of the power terminal in relation to the circuit board. In an alternative embodiment of a power terminal 8" shown in Fig. 8, the alignment pin is omitted. Instead, a lower surface 9' of the main body 8a is arranged to provide friction between the main body and the circuit board. Particularly in smaller terminals, this friction, together with the mounting screw 13a, is sufficient to prevent rotation of the terminal. The lower surface 9' can be rough so as to increase the friction between the surface and the circuit board. Alternatively, the surface can be provided with adhesive or glue to increase the friction.

In Fig. 9, yet an alternative embodiment of a terminal according to the invention is shown. In this embodiment, the space adjacent to the eccentric body extends below the main body. This gives further space for components mounted on the circuit board.

In the embodiments shown in Figs. 8 and 9, the clamping force exerted by a screw through the eccentric body may be sufficient to create a friction between the terminal and the circuit board that prevents turning of the terminal in relation to the circuit board.

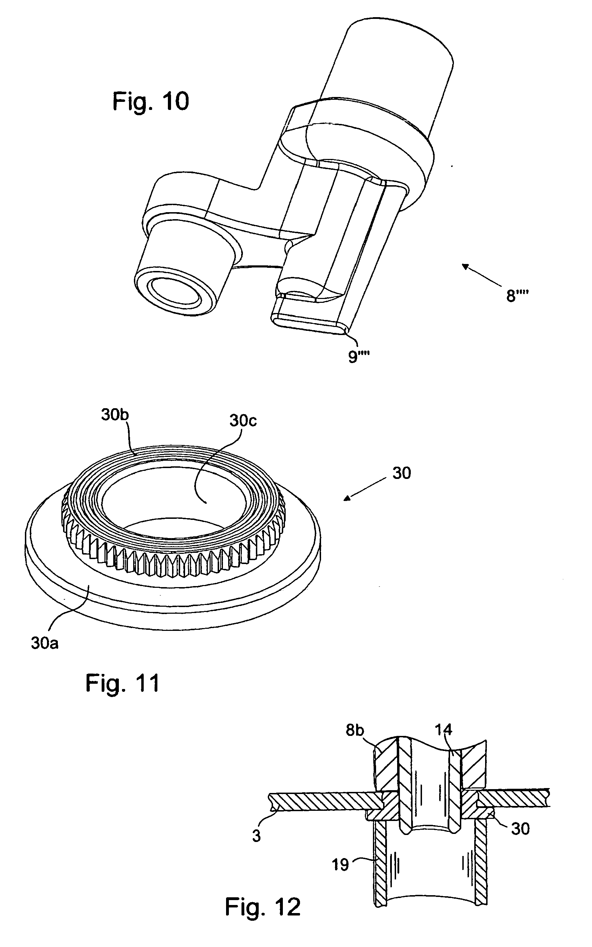

In Fig. 10, an alternative embodiment of a terminal according to the invention is shown, generally designated 8'''', wherein the alignment pin 9 has been replaced by a fin-shaped protrusion 9''''. This protrusion is arranged to be inserted into an elongated opening in the circuit board.

The fin-shaped protrusion provides good anti-rotation function and a rugged construction.

A standoff or distance for use with a terminal according to the invention is shown in Fig. 11. The standoff, designated 30, comprises a circular smooth portion 30a having larger diameter and a circular teethed portion 30b having smaller diameter. A circular through hole 30c is provided for reception of the insulator 14 provided in the eccentric portion 8b of the terminal.

The standoff 30 is made of some suitable thermally and electrically conductive material, such as brass.

The standoff 30 is mounted from below in a circular hole in the control board 3 and retained therein by means of press fit, wherein the teeth of the teethed portion 30b engage the rim of the hole in the control board, see Fig. 12. The eccentric portion 8b abuts the top of the standoff 30 and the insulator 14 extends through the hole 30c in the standoff. The current spacer 19 abuts the larger diameter portion of the standoff 30 from below.

By means of the standoff 30, the terminal arrangement allows for higher currents and higher temperatures. Also, the arrangement is sturdier than without the standoff.

Preferred embodiments of a power terminal according to the invention and a drive unit comprising such power terminal have been described. A person skilled in the art realizes that this could be varied within the scope of the appended claims.

The inventive power terminal has been described as being electrically connected to a circuit board. It will be appreciated that the term circuit board covers other means for mounting circuits and conducting electricity, such as bus bars etc.

Rolling gaskets 25, 29 have been described as preferred means for water protection. It will be appreciated that such gaskets can be used also together with other kinds of terminals than the described one.

Instead of cables 11, other means, such as bus bars, can be used for connecting to the inventive power terminal.

A drive unit for electrical motors has been described as one kind of unit in which the terminal according to the invention can be used. It will be appreciated that the terminal can be used in other units as well.

## Claims

1. A power terminal for electrical connection of an electric cable to a circuit board, the terminal comprising:
- a main body (8a) having a central longitudinal axis;
- means (12, 12a) for attaching a cable to the main body;
**characterized by**
- an eccentric body (8b) integral with the main body (8a) and having a through hole (13) arranged to receive a screw,
- wherein a space (20) is provided at the bottom of the power terminal adjacent to the eccentric body and between the main body and the eccentric body.

2. The power terminal according to claim 1, wherein the space (20) provided at the bottom of the power terminal is arranged to receive a current measurement device (22, 23).

3. The power terminal according to any of claims 1 and 2, wherein a means for maintaining a lateral position of the power terminal in relation to the circuit board comprises a pin (9) or a fin-shaped protrusion (9"") on the main body for positioning in a hole in the circuit board.

4. The power terminal according to any of claims 1-3, wherein a means (9') for maintaining a lateral position of the power terminal in relation to the circuit board comprises a lower surface of the power terminal providing friction between the power terminal and the circuit board.

5. The power terminal according to any of claims 1-4, wherein an upper surface of the eccentric body (8b) is conical.

6. The power terminal according to any of claims 1-5, comprising an electrical insulator (14) provided in the through hole (13).

7. The power terminal according to any of claims 1-6, wherein the main body (8a) has a drafted outer surface (24).

8. The power terminal according to claim 7, comprising a gasket (25) provided on the outer surface of the main body (8a).

9. The power terminal according to any of claims 1-8, comprising an additional eccentric body (8b) integral with the main body (8a) and having a through hole (13) arranged to receive a screw.

10. A unit (1) comprising a cover (6) and a circuit board (3, 4), **characterized by** a power terminal according to any of claims 1-9 provided in a hole through the cover and being mechanically and electrically connected to the circuit board.

11. The unit according to claim 10, wherein a current measurement device (22) is provided on the circuit board (3) in the space (20) of the terminal.

12. The unit according to claim 10 or 11, wherein the inner surface of the hole in the cover is drafted for cooperation with a gasket (25; 29) provided on the power terminal (8).

13. The unit according to claim 12, wherein the gasket (29) is multi-flanged.

14. The unit according to any of claims 11-13, comprising an upper and a lower mutually parallel circuit board (3, 4), wherein the power terminal is mechanically and electrically connected to the upper circuit board, a heat sink (5) is provided below the lower circuit board, and a current spacer (19) is provided between the upper and lower circuit boards.

15. The unit according to any of claims 11-14, comprising a thermally and electrically conductive standoff (30) provided in a hole in the circuit board (3), wherein the eccentric body of the terminal abuts the standoff.

## Patentansprüche

1. Stromanschlussstück zur elektrischen Verbindung eines Elektrokabels mit einer Leiterplatte, wobei das Anschlussstück aufweist:
- einen Hauptkörper (8a) mit einer mittigen Längsachse;
- Mittel (12, 12a) zum Befestigen eines Kabels an dem Hauptkörper;
**gekennzeichnet durch**
- einen exzentrischen Körper (8b), der mit dem Hauptkörper (8a) einstückig ist und eine Durchgangsöffnung (13) aufweist, die angeordnet ist, um eine Schraube aufzunehmen,
- wobei ein Raum (20) an der Unterseite des Stromanschlussstücks benachbart zu dem exzentrischen Körper und zwischen dem Hauptkörper und dem exzentrischen Körper vorgesehen ist.

2. Stromanschlussstück nach Anspruch 1, wobei der an der Unterseite des Stromanschlussstücks vorgesehene Raum (20) angeordnet ist, um eine Strommessvorrichtung (22, 23) aufzunehmen.

3. Stromanschlussstück nach einem der Ansprüche 1 und 2, wobei ein Mittel zum Aufrechterhalten einer seitlichen Position des Stromanschlussstücks relativ zu der Leiterplatte einen Zapfen (9) oder einen rippenförmigen Vorsprung (9"") an dem Hauptkörper zur Positionierung in einer Öffnung in der Leiterplatte aufweist.

4. Stromanschlussstück nach einem der Ansprüche 1-3, wobei ein Mittel (9') zum Aufrechterhalten einer seitlichen Position des Stromanschlussstücks relativ zu der Leiterplatte eine untere Fläche des Stromanschlussstücks aufweist, die Reibung zwischen dem Stromanschlussstück und der Leiterplatte schafft.

5. Stromanschlussstück nach einem der Ansprüche 1-4, wobei eine obere Fläche des exzentrischen Körpers (8b) konisch ist.

6. Stromanschlussstück nach einem der Ansprüche 1-5, aufweisend einen elektrischen Isolator (14), der in der Durchgangsöffnung (13) vorgesehen ist.

7. Stromanschlussstück nach einem der Ansprüche 1-6, wobei der Hauptkörper (8a) eine verjüngte Außenfläche (24) hat.

8. Stromanschlussstück nach Anspruch 7, aufweisend eine Dichtung (25), die an der Außenfläche des Hauptkörpers (8a) vorgesehen ist.

9. Stromanschlussstück nach einem der Ansprüche 1-8, aufweisend einen zusätzlichen exzentrischen Körper (8b), der mit dem Hauptkörper (8a) einstückig ist und eine Durchgangsöffnung (13) aufweist, die angeordnet ist, um eine Schraube aufzunehmen.

10. Einheit (1), aufweisend eine Abdeckung (6) und eine Leiterplatte (3, 4), **gekennzeichnet durch** ein Stromanschlussstück nach einem der Ansprüche 1-9, das in einer Öffnung **durch** die Abdeckung hindurch vorgesehen und mit der Leiterplatte mechanisch und elektrisch verbunden ist.

11. Einheit nach Anspruch 10, wobei eine Strommessvorrichtung (22) an der Leiterplatte (3) in dem Raum (20) des Anschlussstücks vorgesehen ist.

12. Einheit nach Anspruch 10 oder 11, wobei die Innenfläche der Öffnung in der Abdeckung zum Zusammenwirken mit einer an dem Stromanschlussstück (8) vorgesehenen Dichtung (25; 29) verjüngt ist.

13. Einheit nach Anspruch 12, wobei die Dichtung (29) mehrbündig ist.

14. Einheit nach einem der Ansprüche 11-13, aufweisend eine obere und eine untere gegenseitig parallele Leiterplatte (3, 4), wobei das Stromanschlussstück mit der oberen Leiterplatte mechanisch und elektrisch verbunden ist, ein Kühlkörper (5) unter der unteren Leiterplatte vorgesehen ist, und ein Stromabstandshalter (19) zwischen der oberen und der unteren Leiterplatte vorgesehen ist.

15. Einheit nach einem der Ansprüche 11-14, aufweisend einen thermisch und elektrisch leitenden Abstandsbolzen (30), der in einer Öffnung in der Leiterplatte (3) vorgesehen ist, wobei der exzentrische Körper des Anschlussstücks an dem Abstandsbolzen anliegt.

## Revendications

1. Borne d'alimentation destinée à la connexion électrique d'un câble électrique à une carte de circuit, la borne comprenant :
un corps principal (8a) ayant un axe longitudinal central ;
des moyens (12, 12a) permettant de fixer un câble au corps principal ;
**caractérisée par**
- un corps excentré (8b) intégré au corps principal (8a) et ayant un trou débouchant (13) fait pour recevoir une vis,
- dans laquelle un espace (20) est prévu dans le bas de la borne d'alimentation adjacent au corps excentré et entre le corps principal et le corps excentré.

2. Borne d'alimentation selon le revendication 1, dans laquelle l'espace (20) prévu en bas de la borne d'alimentation est fait pour accueillir un dispositif de mesure de courant (22, 23).

3. Borne d'alimentation, selon l'une quelconque de la revendication 1 et de la revendication 2, dans laquelle un moyen permettant de maintenir une position latérale de la borne d'alimentation par rapport à la carte de circuit comprend un ergot (9) ou une protubérance en forme de dérive (9"") sur le corps principal permettant le positionnement dans un orifice dans la carte de circuit.

4. Borne d'alimentation selon l'une quelconque des revendications 1 à 3, dans laquelle un moyen (9') permettant de maintenir une position latérale par rapport à la carte de circuit comprend une surface inférieure de la borne d'alimentation fournissant un frottement entre la borne d'alimentation et la carte de circuit.

5. Borne d'alimentation selon l'une quelconque des revendications 1 à 4, dans laquelle une surface supérieure du corps excentré (8b) est conique.

6. Borne d'alimentation selon l'une quelconque des revendications 1 à 5, comprenant un isolant électrique (14) pourvu du trou débouchant (13).

7. Borne d'alimentation selon l'une quelconque des revendications 1 à 6, dans laquelle le corps principal (8a) a une surface extérieure à section transversale réduite (24).

8. Borne d'alimentation selon la revendication 7, comprenant un joint (25) prévu sur la surface extérieure du corps principal (8a).

9. Borne d'alimentation selon l'une quelconque des revendications 1 à 8, comprenant un corps excentré supplémentaire (8b) intégré au corps principal (8a) et ayant un trou débouchant (13) fait pour accueillir une vis.

10. Unité (1) comprenant un couvercle (6) et une carte de circuit (3, 4), **caractérisée par** une borne d'alimentation selon l'une quelconque des revendications 1 à 9 prévue dans un orifice à travers le couvercle et mécaniquement et électriquement connectée à la carte de circuit.

11. Unité selon la revendication 10, dans laquelle un dispositif de mesure de courant (22) est prévu sur la carte de circuit (3) dans l'espace de la borne.

12. Unité selon la revendication 10 ou 11, dans laquelle la surface intérieure du trou dans le couvercle est à section transversale réduite pour coopérer avec un joint (25 ; 29) prévu sur la borne d'alimentation (8).

13. Unité selon la revendication 12, dans laquelle le joint (29) est à plusieurs collerettes.

14. Unité selon l'une quelconque des revendications 11 à 13, comprenant une carte de circuit supérieure et une carte de circuit inférieur (3, 4) parallèles l'une par rapport à l'autre, dans laquelle la borne d'alimentation est connectée mécaniquement et électriquement à la carte de circuit supérieure, un puits de chaleur (5) est prévu sous la carte de circuit inférieure, et une entretoise courante (19) est prévue entre les cartes de circuit supérieure et inférieure.

15. Unité selon l'une quelconque des revendications 11 à 14, comprenant une séparation thermiquement et électriquement conductrice (30) prévue dans un orifice dans la carte de circuit (3), dans laquelle le corps excentré de la borne vient en aboutement contre la séparation.
